# EUROPEAN PATENT APPLICATION

(11) **EP 1 830 456 A1**
(43) Date of publication of application: **05.09.2007**
(21) Application number: 05819553.8
(22) Date of filing: 22.12.2005
(51) Int. Cl.: H02K 41/02, G03F 7/20, H01L 21/027, H01L 21/68

(54) **MAGNETIC GUIDING APPARATUS, STAGE APPARATUS, EXPOSURE APPARATUS AND DEVICE MANUFACTURING METHOD**

(30) Priority: 24.12.2004 JP 2004372923
(71) Applicant: NIKON CORPORATION, Tokyo 100-8831 (JP)
(72) Inventor: ONO, Kazuya, c/o NIKON CORPORATION, Tokyo 1008331 (JP); TANIMURA, Hisashi, c/o NIKON CORPORATION, Tokyo 1008331 (JP); TAKAIWA, Hiroaki, c/o NIKON CORPORATION, Tokyo 1008331 (JP)
(74) Representative: Hooiveld, Arjen Jan Winfried
(86) International application number: PCT/JP2005/023620
(87) International publication number: WO 2006/068233

(57) **Abstract**

A magnetic guide apparatus (100) includes a guide member (110) that has a guide plane (111) provided along a first direction, and a moving body (120) that has a facing plane (121) facing the guide plane (111) to be spaced apart from the guide plane (111). Magnetic attractive force is permitted to operate between the guide plane (111) and the facing plane (121), such that the moving body (120) is moved along the first direction while movement to a second direction, which is orthogonal to the first direction and parallel to the guide plane (111), is controlled. A first groove section (112) is formed along the first direction on the guide plane (111) and a second groove section (122) is formed along the first direction so as to face the first groove section (112) on the facing plane (121).

## Description

### TECHNICAL FIELD

The present invention relates to a magnetic guide apparatus, a stage apparatus, an exposure apparatus and the like using such a magnetic guide apparatus.

This application claims priority to Japanese Patent Application No. 2004-372923 filed on December 24, 2004, the disclosure of which is incorporated herein by reference in its entirety.

### BACKGROUND ART

There has been known a micro lithography apparatus that forms a circuit pattern of a semiconductor device, a liquid crystal display device or the like by irradiating illumination light (energy beams, such as ultraviolet rays, X rays, electron beams or the like) onto a mask or the like having depicted thereon a circuit pattern and projecting and exposing a pattern image to a sensitive substrate (a semiconductor wafer, a glass plate or the like having coated thereon a resist layer) through a projection optical system having an equal ratio, or a predetermined reduction ratio or magnification ratio. In such a lithography apparatus, a stage apparatus (a mask stage or a substrate stage) on which a mask or a sensitive substrate is placed and precisely moved within a plane under the position servo control of a laser interferometer is provided.

In the stage apparatus, in order to move a movable stage main body in a predetermined direction, a guide apparatus that includes a guide member and a moving body is provided between the movable stage main body and a base or the like. There has been suggested a stage apparatus that uses a magnetic guide apparatus for generating magnetic attractive force between the guide member and the moving body so as to control movement in a direction (non-movement direction) orthogonal to a movement direction.

Patent Document 1 : Japanese Patent Application, Publication No. 2004-132435

### DISCLOSURE OF INVENTION

### PROBLEMS TO BE SOLVED BY THE INVENTION

According to the above-described magnetic guide apparatus, complexity of the adjustment can be prevented or costs can be reduced. However, since the moving body is only restricted by the magnetic attractive force with respect to the guide member in a non-contact manner, a restrictive force to the non-movement direction (that is, a restoration force by the magnetic attractive force) is made small. For this reason, a resonance frequency of the movable stage main body decreases, which causes the control performance of the stage apparatus to be reduced.

The invention has been finalized in consideration of the above problem, and it is an object of the invention to provide a magnetic guide apparatus that permits magnetic attractive force to be operated between a guide member and a moving body, and, in particular, can easily improve a restrictive force to a direction orthogonal to a movement direction, and a stage apparatus, an exposure apparatus and the like using such a magnetic guide apparatus.

### MEANS FOR SOLVING THE PROBLEM

In order to solve the above problem, according to this invention, a magnetic guide apparatus, a stage apparatus, an exposure apparatus, and a device manufacturing method use the following structures.

According to an aspect of the invention, a magnetic guide apparatus (100) includes a guide member (110) that has a guide plane (111) provided along a first direction, and a moving body (120) that has a facing plane (121) facing the guide plane to be spaced apart from the guide plane. Magnetic attractive force is permitted to operate between the guide plane and the facing plane, such that the moving body (120) is moved along the first direction while movement to a second direction, which is substantially orthogonal to the first direction and parallel to the guide plane (111), is controlled. A first groove section (112) is formed along the first direction on the guide plane and a second groove section (122) is formed along the first direction on the facing plane so as to face the first groove section.

With this structure, the grooves are respectively formed on the guide plane and the facing plane so as to face each other. Therefore, a force that controls the movement of the moving body to the second direction, which is substantially orthogonal to the first direction and parallel to the guide plane, can be easily improved.

A plurality of groove sections (112 and 122) may be formed on each of the guide plane (111) and the facing plane (121). With this structure, the force that controls the movement of the moving body to the second direction, which is substantially orthogonal to the first direction and parallel to the guide plane, can be easily increased.

The guide member (110) or the moving body (120) may have a magnet member (125) that, through the guide plane (111) and the facing plane (121), forms a magnetic circuit (M) within a plane substantially orthogonal to each of the first direction and the facing plane. With this structure, movement of the moving body to the first direction can be smoothly performed, compared with a case where a magnetic circuit is formed within a plane substantially parallel to the first direction.

The magnetic circuit (M) may be formed in two or more. With this structure, the force that controls the movement of the moving body to the second direction, which is substantially orthogonal to the first direction and parallel to the guide plane, can be easily increased.

The magnet member (125) may be a plurality of permanent magnets (125) that are arranged with alternating polarities. With this structure, a plurality of magnetic circuits can be easily formed.

The magnet member (125) may be a plurality of electromagnets that are arranged with alternating polarities. With this structure, a plurality of magnetic circuits can be easily formed.

The moving body (120) or the guide member (110) may be configured to reduce a resistive force to the moving body to be generated when the moving body moves along the guide plane (111). With this structure, since the resistive force to the moving body is reduced, the moving body can be smoothly guided with a small force.

When the guide member (110) has the magnet member (125), the moving body (120) may be configured to reduce the resistive force to the moving body to be generated when the moving body moves along the guide plane (111). Further, when the moving body has the magnet member, the guide member may be configured to reduce the resistive force to the moving body to be generated when the moving body moves along the guide plane. With this structure, since the resistive force to the moving body is reduced, the moving body can be smoothly guided with a small force.

The moving body (120) or the guide member (110) may have a laminate (116) in which a plurality of plate members (114 or 115) are laminated. With this structure, when the moving body moves along the guide member, an eddy current rarely occurs in the moving body or the guide member. Therefore, the resistive force to the moving body is reduced, and thus the moving body can be smoothly guided.

In the laminate (116 or 117), each of interfaces (114a or 115a) of the plurality of plate members (114 or 115) may be substantially parallel to a plane that is substantially orthogonal to each of the first direction and the facing plane (121). With this structure, an eddy current can be reliably prevented from occurring in the moving body or the guide member.

In the laminate (116 or 117), each of interfaces (114a or 115a) of the plurality of plate members (114 or 115) may be substantially parallel to a plane that is substantially orthogonal to each of the second direction and the facing plane (121). With this structure, an eddy current can be reliably prevented from occurring in the moving body or the guide member.

A width of a protruding portion (113 or 123) of the facing plane (121) excluding the groove section (112 or 122) may be defined by a permissible movement distance of the plate members (114 or 115) to the second direction. With this structure, the permissible movement distance can be easily adjusted using the relationship between the permissible movement distance of the moving body to the second direction and the width of the protruding portion.

A width of a protruding portion (113 or 123) of the facing plane (121) excluding the groove section (112 or 122) may be defined on the basis of a relational expression in respects to a length of the facing plane in the first direction and a saturated magnetic flux density of each of the plate members (114 or 115). With this structure, the permissible movement distance can be easily adjusted.

According to another aspect of the invention, a magnetic guide apparatus (100) includes a guide member (110) that has a guide plane (111) provided along a first direction, and a moving body (120) that has a facing plane (121) facing the guide plane to be spaced apart from the guide plane. Magnetic attractive force is permitted to operate between the guide plane and the facing plane, such that the moving body is moved along the first direction while movement to a second direction, which is substantially orthogonal to the first direction and parallel to the guide plane, is controlled. Either the guide member or the moving body has a magnet member that, through the guide plane and the facing plane, forms a magnetic circuit (M) within a plane substantially orthogonal to each of the first direction and the facing plane.

With this structure, the movement of the moving body to the first direction can be smoothly performed, compared with a case where a magnetic circuit is formed within a plane substantially parallel to the first direction.

The magnetic circuit (M) may be formed in two or more. With this structure, a force that controls the movement of the moving body to the second direction, which is substantially orthogonal to the first direction and parallel to the guide plane, can be easily increased.

According to still another aspect of the invention, a magnetic guide apparatus (100) includes a guide member (110) that has a guide plane (111) provided along a first direction, and a moving body (120) that has a facing plane (121) facing the guide plane to be spaced apart from the guide plane. Magnetic attractive force is permitted to operate between the guide plane and the facing plane, such that the moving body is moved along the first direction while movement to a second direction, which is substantially orthogonal to the first direction and parallel to the guide plane, is controlled. Either the guide member or the moving body has a magnet member (125) that forms a magnetic circuit (M) through the guide plane and the facing plane. The guide member or the moving body is configured to reduce a resistive force to the moving body to be generated when the moving body moves along the guide plane.

With this structure, when the moving body moves in the first direction, the resistive force to the moving body to be generated by movement of the magnetic circuit is reduced. Therefore, the moving body can be smoothly guided with a small force.

The moving body (120) or the guide member (110) may have a laminate (116 or 117) in which a plurality of plate members (114 or 115) are laminated. With this structure, when the moving body moves along the guide member, an eddy current rarely occurs in the moving body or the guide member. Therefore, the resistive force to the moving body can be reduced, and thus the moving body can be smoothly guided.

In the laminate (116 or 117), each of interfaces (114a or 115a) of the plurality of plate members (114 or 115) may be substantially parallel to a plane that is substantially orthogonal to each of the first direction and the facing plane (121). With this structure, an eddy current can be reliably prevented from occurring in the moving body or the guide member.

In the laminate (116 or 117), each of interfaces (114a or 115a) of the plurality of plate members (114 or 115) may be substantially parallel to a plane that is substantially orthogonal to each of the second direction and the facing plane (121). With this structure, an eddy current can be reliably prevented from occurring in the moving body or the guide member.

According to yet still another aspect of the invention, a stage apparatus (20) includes a base (23) and a stage (21) that is relatively movable with respect to the base. The above-described magnetic guide apparatus (100) is used as a guide apparatus that is disposed between the base and the stage to relatively move the base and the stage only in a predetermined direction.

With this structure, since a restrictive force to a direction orthogonal to a movement direction is high, controllability of the stage apparatus can be improved.

The base (23) may have a guide plane (111) and a bearing plane (152) that is provided at a different position from the guide plane, and the stage (21) may have the moving body (120) and fluid bearings (150) that are provided to face the bearing plane to support the stage. With this structure, since the guide plane and the facing plane of the magnetic guide apparatus can be spaced by a predetermined distance, stable guidance can be realized.

The fluid bearings (150) may be disposed at both sides of the magnetic guide apparatus (100) relative to the second direction. With this structure, the guide plane and the facing plane of the magnetic apparatus can be easily prevented from relatively rotating.

A plurality of magnetic guide apparatuses (100) may be provided in pairs, and at least a pair of magnetic guide apparatuses may be disposed such that magnetic attractive force, which is generated by one magnetic guide apparatus and operates between the guide plane (111) and the facing plane (121), and magnetic attractive force, which is generated by the other magnetic guide apparatus and operates between the guide plane and the facing plane, are substantially offset with each other. With this structure, magnetic attractive forces of the pair of magnetic guide apparatuses are substantially offset with each other (balancing is achieved). Therefore, the guide plane and the facing plane can be easily spaced by a predetermined distance without using a special apparatus.

The stage apparatus (20) may further include an actuator (24) that relatively moves the base (23) and the stage (21) and generates attractive force operating between the base and the stage. Magnetic attractive force to be generated by the magnetic guide apparatus (100) may be substantially offset by attractive force to be generated by the actuator. With the actuator provided in the stage apparatus, the guide plane and the facing plane of the magnetic guide apparatus can be easily spaced by a predetermined distance without using a special apparatus.

A mass body (24a) that moves according to movement of the stage (21) to suppress a reaction force to be generated by the movement of the stage (21) may be provided, and the above-described magnetic guide apparatus (100) may be used as a guide apparatus that guides the mass body. With this structure, since the mass body can be smoothly guided, the reaction force of the movement of the stage can be smoothly suppressed.

According to yet still another aspect of the invention, a stage apparatus (20) includes a base (23) that has a guide plane (111) provided along a first direction, a stage (21) that has a facing plane (121) facing the guide plane to be spaced apart from the guide plane and is movable along the first direction while movement of a second direction, which is substantially orthogonal to the first direction and parallel to the guide plane, is controlled, by magnetic attractive force operating between the guide plane and the facing plane, and fluid bearings (150) that are provided between the base and the stage at a different position from the guide plane to support the stage with respect to the base.

With this structure, relative movement can be smoothly performed while the stage can be supported on the base in a non-contact manner.

The fluid bearings (150) may be disposed at both sides of the guide plane (111) or the facing plane (121) relative to the second direction. With this structure, rotation of the stage can be reliably suppressed.

According to yet still another aspect of the invention, an exposure apparatus (EX) that exposes a pattern (PA) formed in a mask to a substrate includes a mask stage (20) that holds the mask (R), and a substrate stage (40) that holds the substrate (W). The above-described stage apparatus (20) is used for at least one of the mask stage and the substrate stage.

With this structure, since a stage apparatus having high controllability is used, a minute pattern can be exposed to the substrate.

According to yet still another aspect of the invention, there is provided an exposure apparatus (EX) that forms a predetermined pattern (PA) in a substrate (W) held by a substrate stage (40). The above-described stage apparatus (20) is used as the substrate stage. With this structure, positioning precision of the substrate can be improved.

According to yet still another aspect of the invention, a device manufacturing method includes a lithography process. In the lithography process, the above-described exposure apparatus (EX) is used.

With this structure, a high-performance device can be efficiently manufactured.

### ADVANTAGE OF THE INVENTION

According to the aspects of the invention, the following effects can be obtained.

According to the magnetic guide apparatus of the aspects of the invention, the force that controls the movement of the moving body to the second direction, which is substantially orthogonal to the first direction and parallel to the guide plane, can be easily improved. Further, the movement of the moving body to the first direction can be smoothly performed. As a result, the stage apparatus can be driven with a small force.

According to the stage apparatus of the aspects of the invention, rigidity in the direction orthogonal to the movement direction of the stage can be improved, and thus highly precise control can be realized.

According to the exposure apparatus of the aspects of the invention, the minute pattern PA can be exposed on the wafer W.

According to the device manufacturing method of the aspects of the invention, a high-performance device can be efficiently manufactured.

### BRIEF DESCRIPTION OF THE DRAWINGS

FIG. I is a schematic configuration diagram showing an exposure apparatus.
FIG. 2 is a perspective view showing the details of a reticle stage.
FIG. 3A is a perspective view of a guide apparatus.
FIG. 3B is a cross-sectional view of the guide apparatus.
FIG. 4A is an enlarged cross-sectional view of the guide apparatus.
FIG. 4B is an enlarged cross-sectional view of the guide apparatus.
FIG. 5 is a diagram showing the arrangement of the guide apparatus and air bearings.
FIG. 6A is a perspective view showing a modification of the guide apparatus.
FIG. 6B is a perspective view showing a modification of the guide apparatus.
FIG. 7A is a perspective view showing a modification of the guide apparatus.
FIG. 7B is a perspective view showing a modification of the guide apparatus.
FIG. 8A is a diagram showing the arrangement of the guide apparatus.
FIG. 8B is a diagram showing the arrangement of the guide apparatus.
FIG. 9 is a flowchart showing an example of a manufacturing process of a microdevice.
FIG. 10 is a diagram showing an example of a detailed process of a wafer processing step in FIG. 9.

### DESCRIPTION OF THE REFERENCE SYMBOLS

- 20:: RETICLE STAGE (STAGE APPARATUS, MASK STAGE)
- 21:: RETICLE COARSE MOVEMENT STAGE (STAGE)
- 23:: RETICLE PLATFORM (BASE)
- 24:: LINEAR MOTOR (ACTUATOR)
- 24a:: STATOR (MASS BODY)
- 40:: WAFER STAGE (STAGE APPARATUS, SUBSTRATE STAGE)
- 100:: GUIDE APPARATUS (MAGNETIC GUIDE APPARATUS)
- 110:: GUIDE (GUIDE MEMBER)
- 111:: GUIDE PLANE
- 112:: GROOVE (FIRST GROOVE SECTION)
- 113:: PROTRUDING PORTION
- 114,115:: PLATE MEMBER
- 114a, 115a:: INTERFACE
- 116, 117:: LAMINATE
- 120:: SLIDER (MOVING BODY)
- 121:: FACING PLANE
- 122:: GROOVE (SECOND GROOVE SECTION)
- 123:: PROTRUDING PORTION
- 125:: PERMANENT MAGNET (MAGNET MEMBER)
- 150:: AIR BEARING (FLUID BEARING)
- 152:: BEARING PLANE
- 200:: GUIDE APPARATUS (MAGNETIC GUIDE APPARATUS)
- 210:: GUIDE APPARATUS (MAGNETIC GUIDE APPARATUS)
- EX:: EXPOSURE APPARATUS
- M:: MAGNETIC CIRCUIT
- R:: RETICLE (MASK)
- PA:: PATTERN
- W:: WAFER (SUBSTRATE)

### BEST MODE FOR CARRYING OUT THE INVENTION

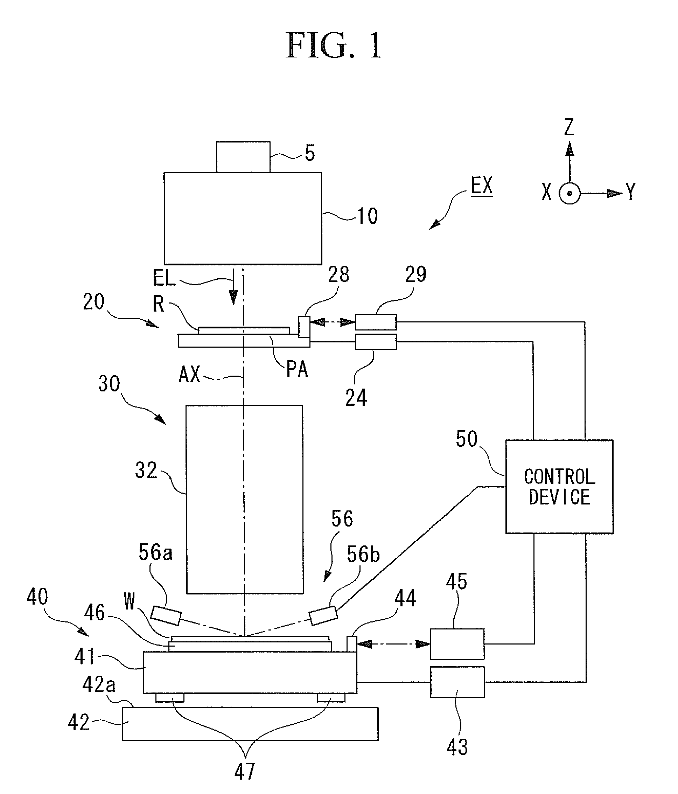

Hereinafter, embodiments of a magnetic guide apparatus, a stage apparatus, an exposure apparatus, and a device manufacturing method of the invention will be described with reference to the drawings. FIG. 1 is a schematic configuration diagram showing an exposure apparatus EX of the invention.

The exposure apparatus EX is a step-and-scan type scanning exposure apparatus that, while synchronously moving a reticle (mask) R and a wafer (substrate) W in a unidimensional direction, transfers a pattern PA formed in the reticle R onto each short area of the wafer W through a projection optical system 30, that is, a so-called scanning stepper.

The exposure apparatus EX includes an exposure light source 5 that emits exposure light EL, an illumination optical system 10 that illuminates the reticle R with exposure light EL, a reticle stage 20 that is movable while holding the reticle R, a projection optical system 30 that projects exposure light EL to be emitted from the reticle R onto the wafer W, a wafer stage 40 that is movable while holding the wafer W by a wafer holder 46, and a control device 50 that performs the overall control of the exposure apparatus EX.

In the following description, a direction that is consistent with an optical axis AX of the projection optical system 30 is referred to as a Z direction, and the synchronous movement direction (scanning direction) of the reticle R and the wafer W within a plane perpendicular to the Z direction is referred to as a Y direction. Further, a direction (non-scanning direction) perpendicular to both the Z direction and the Y direction is referred to as an X direction. In addition, rotation (inclination) directions around the X direction, the Y direction, and the Z direction are referred to as a θX direction, a θY direction, and a θZ direction, respectively.

As exposure light EL to be emitted from the exposure light source 5, an emission lines (g-ray, h-ray, and i-ray) in an ultraviolet region emitted from a mercury lamp, deep ultraviolet beams (DUV light beams), such as KrF excimer laser beam (248 nm wavelength), or vacuum ultraviolet light beams (VUV light beams), such as ArF excimer laser beam (193 nm wavelength) and F₂ laser beam (157 nm wavelength), may be used.

The illumination optical system 10 illuminates the reticle R supported on the reticle stage 20 with exposure light EL. The illumination optical system 10 has an optical integrator (not shown) that uniformizes illuminance of exposure light EL emitted from the exposure light source, a condenser lens (not shown) that condenses exposure light EL from the optical integrator, a relay lens system (not shown), a variable field stop (not shown) that sets illumination area on the reticle R by exposure light EL in a slit shape, and the like. A predetermined illumination area on the reticle R is illuminated with exposure light EL having a uniform distribution of illuminance by the illumination optical system 10.

The reticle stage (stage apparatus or mask stage) 20 is movable while holding the reticle R, and fixes the reticle R by, for example, vacuum absorption (or electrostatic attraction). The reticle stage 20 is movable in a two-dimensional direction within a plane perpendicular to the optical axis AX of the projection optical system 30, that is, an XY plane, and is minutely rotatable in the θz direction. The reticle stage 20 is driven by a linear motor 24 and a voice coil motor 25.

A movable mirror 28 is provided on the reticle stage 20, and a laser interferometer 29 is provided at a position facing the movable mirror 28. The movable mirror 28 is a mirror for the laser interferometer 29 that measures a position of the reticle stage 20. With this structure, a position of the reticle R in the two-dimensional direction (XY direction) on the reticle stage 20 and a rotation angle in the θZ direction (as occasion demands, including rotation angles in the θX direction and the θY direction) are measured by the laser interferometer 29 in real time. The measurement result of the laser interferometer 29 is output to a control device 50, and the control device 50 drives the linear motor 24 and the voice coil motor 25 on the basis of the measurement result of the laser interferometer 29. Then, the position of the reticle R supported on the reticle stage 20 is controlled.

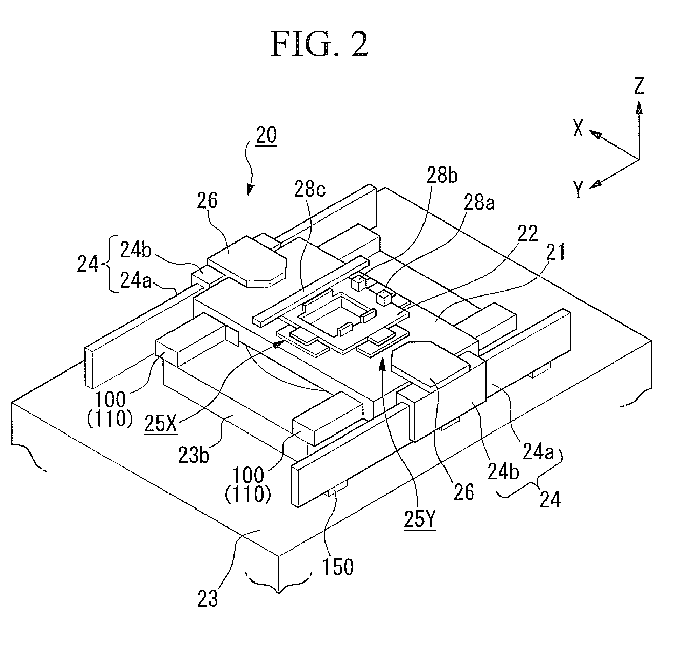

FIG. 2 is a perspective view showing the details of the reticle stage 20.

The reticle stage 20 includes a reticle coarse movement stage (stage) 21 that is driven by a pair ofY linear motors 24 on the reticle platform (base) 23 with a predetermined stroke, and a reticle fine movement stage 22 that is minutely driven by a pair of X voice coil motors 25X and a pair ofY voice coil motors 25Y on the reticle coarse movement stage 21 in the X direction, the Y direction, and the θZ direction.

Each of the Y linear motors (actuators) 24 has a stator (mass body) 24a that is floatingly supported by a plurality of air bearings (air pad) 19 as non-contact bearings on the reticle platform 23 to move in the Y direction, and a moving element 24b that is provided to correspond to the stator 24a and fixed to the reticle coarse movement stage 21 through a connection member 26. For this reason, with the momentum conservation law, the stator 24a moves in a -Y direction as a counter mass, in response to movement of the reticle coarse movement stage 21 in a +Y direction. That is, a reaction force accompanied with the movement of the reticle coarse movement stage 21 can be offset by the movement of the stator 24a, and a change in center position of the reticle stage 20 can be prevented.

The reticle coarse movement stage 21 is fixed onto an upper surface of an upper protrusion 23b formed at the center of the reticle platform 23 and is guided in the Y direction by a pair of guide apparatuses 100 extending in the Y direction. Further, the stator 24a is also guided in the Y direction by a guide apparatus 100 (not shown) extending in the Y direction.

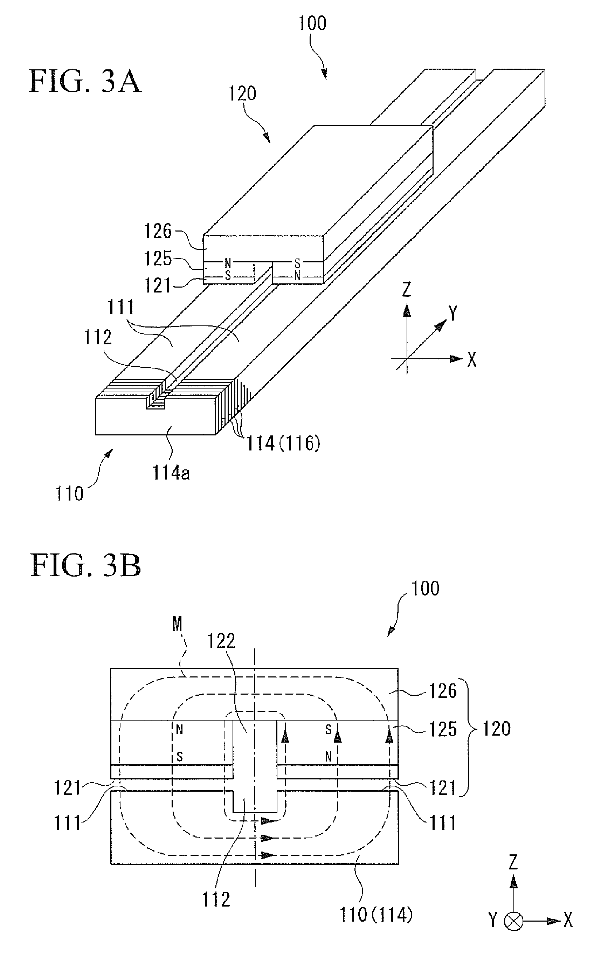

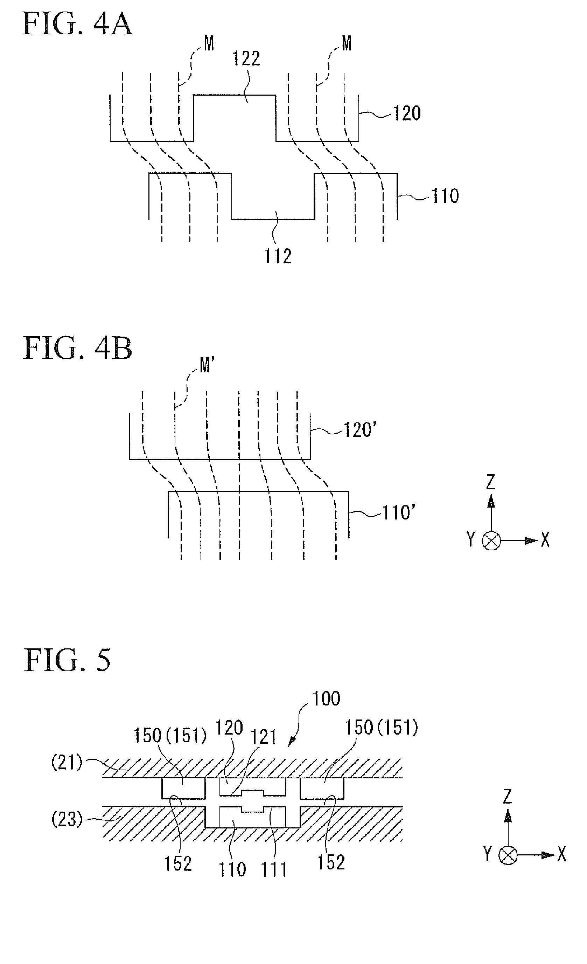

The guide apparatus 100 is a linear guide that has a guide 110 extending in the Y direction on the reticle platform 23 and a slider 120 disposed at the bottom of the reticle coarse movement stage 21 to face the guide 110 (see FIGs. 3A and 3B). In addition, the guide apparatus 100 functions as a magnetic guide that controls a position of the slider 120 in the X direction with respect to the guide 110 by the magnetic attractive force while the guide 110 and the slider 120 are spaced by a predetermined distance. Air bearings 150 (see FIG. 5) are provided at a lower surface of the reticle coarse movement stage 21 such that the reticle coarse movement stage 21 is supported in a non-contact manner with respect to the reticle platform 23. A facing plane of each of the air bearings 150, that is, a bearing plane 152 (see FIG. 5) of each of the air bearings 150 formed in the reticle platform 23 is formed at a different position from a guide plane 111 of the guide apparatus 100. Moreover, the details of the guide apparatus 100 will be described below.

In the reticle fine movement stage 22, the reticle R is absorbed and held by a vacuum chuck (not shown). A pair ofY movable mirrors 28a and 28b formed of a corner cube are fixed at an end of the reticle fine movement stage 22 in the -Y direction, and an X movable mirror 28c formed of a plane mirror extending in the Y direction is fixed at an end of the reticle fine movement stage 22 in the +X direction. Three laser interferometers 29 (see FIG. 1) that directs a length measurement beam onto the movable mirrors 28a, 28b, and 28c measure distances from the respective movable mirrors. Then, the positions of the reticle stage 20 in the X direction, the Y direction, and the θZ direction are measured with high precision.

Returning to FIG. 1, the projection optical system 30 projects and exposes a pattern of the reticle R onto the wafer W at a predetermined projection magnification β. The projection optical system 30 has a plurality of optical elements including an optical element provided at its front end in the side of the wafer W. The optical elements are supported by a lens barrel 32.

The projection optical system 30 is a reduction system that has a projection magnification β of, for example, 1/4, 1/5, or 1/8. Further, the projection optical system 30 may be an equal system or a magnification system. In addition, the optical element at the front end of the projection optical system 30 is detachably (replaceably) provided to the lens barrel 32.

The wafer stage (stage apparatus or substrate stage) 40 supports the wafer W. The wafer stage 40 includes an XYZ stage 41 that is movable to have six-degrees of freedom in the X direction, the Y direction, the Z direction, the θX direction, the θY direction, and the θZ direction while holding the wafer W by the wafer holder 46, and a wafer platform 42 that movably supports the XYZ stage 41 on a guide plane 42a.

The XYZ stage 41 is driven by a wafer stage driving device 43, such as a linear motor or the like. The wafer stage driving device 43 is controlled by the control device 50 and a position of the wafer W in an XY direction (a position substantially parallel to an image plane of the projection optical system 30) is controlled. Further, when the wafer stage driving device 43 is driven, a position of the wafer W held by the wafer holder 46 on the XYZ stage 41 in the Z direction (focus position) is controlled.

A movable lens 44 is provided on the XYZ stage 41, and a laser interferometer 45 is provided at a position facing the movable lens 44. With this arrangement, a position of a two-dimensional direction and a rotation angle of the wafer W on the XYZ stage 41 are measured by the laser interferometer 45 in real time.

The measurement result is output to the control device 50, and the control device 50 drives the XYZ stage 41 through the wafer stage driving device 43 on the basis of the measurement result of the laser interferometer 45 or the like. Then, positioning of the wafer W supported on the XYZ stage 41 in the X direction, the Y direction, and the θZ direction is performed.

Further, the wafer holder 46 that attracts the wafer W is provided at the upper surface of the XYZ stage 41. The XYZ stage 41 is supported on the wafer platform 42 in a non-contact manner by air bearings 47.

A focus detection system 56 that detects a position of the surface of the wafer W (focus position) with respect to the image plane of the projection optical system 30 is disposed above the XYZ stage 41. The focus detection system 56 has a light projecting unit 56a that projects detection light from in an oblique direction with respect to the surface of the wafer W, and a light receiving unit 56b that receives reflected light of detection light reflected at the surface of the wafer W.

The light-receiving result of the light receiving unit 56b is output to the control device 50, and the control device 50 drives the XYZ stage 41 by the wafer stage driving device 43 on the basis of the detection result of the focus detection system 56. Then, positioning of the wafer W supported on the XYZ stage 41 in the Z direction, the θX direction, and the θY direction is performed. In such a manner, the position of the surface of the wafer W falls within a focal depth of the projection optical system 30 (the image plane of the projection optical system 30).

Next, the guide apparatus 100 will be described in detail. FIGs. 3A and 3B are a perspective view and a cross-sectional view of the guide apparatus 100, and FIGs. 4A and 4B are enlarged cross-sectional views of the guide apparatus 100.

The guide apparatus (magnetic guide apparatus) 100 has the guide (guide member) 110 that has the guide plane 111, and the slider (moving body) 120 that has the facing plane 121 facing the guide plane 111. The guide 110 is formed of a ferromagnetic body, such as a carbon steel plate, or an electromagnetic steel plate, such as a silicon steel plate. Further, the slider 120 has the facing plane 121 formed of a ferromagnetic body, such as a carbon steel plate, or an electromagnetic steel plate, such as a silicon steel plate, permanent magnets 125, and a yoke 126. Moreover, the facing plane 121 may be directly formed on the surface (lower surface) of the permanent magnet 125, not using the electromagnetic steel plate or the like.

The slider 120 and the guide 110 are held to be spaced by a predetermined distance by air bearings 150 (see FIG. 5). Accordingly, the guide plane 111 and the facing plane 121 are held to be spaced apart from each other, in the state where magnetic attractive force is generated between the guide plane 111 and the facing plane 121.

Therefore, the slider 120 can smoothly move in the Y direction that is the movement direction af the slider 120 (the extension direction of the guide 110), but the movement to the X direction orthogonal to the movement direction is controlled by the magnetic attractive force.

A plurality of permanent magnets (magnet member) 125 disposed in the slider 120 are arranged with alternating polarities in the direction (X direction) orthogonal to the movement direction (Y direction). Accordingly, as shown in FIG. 3B, a magnetic circuit M is formed through the guide plane 111 and the facing plane 121 within a plane along an XZ plane (a plane substantially orthogonal to the Y direction).

As such, the reason why the permanent magnets 125 are arranged in the direction orthogonal to the movement direction and the magnetic circuit M is formed within the plane along the XZ plane is as follows. In the known guide apparatus, the permanent magnets 125 provided on the facing plane of the slider are arranged along the movement direction. For this reason, a magnetic circuit is formed within a plane substantially parallel to a YZ plane (within a plane substantially parallel to the movement direction) through the guide plane and the Facing plane. If the magnetic circuit is formed within the plane substantially parallel to the movement direction, when a point within the guide plane of the guide is referred to, the magnetic circuit passes accompanied by the movement of the slider, and the direction of a magnetic flux is reversed from an N pole to an S pole or from the S pole to the N pole. For this reason, by need to reverse the direction of the magnetic flux, a force to be generated by magnetic hysteresis becomes large. This force forms large viscous resistance and then interferes with high-speed movement of the slider.

Meanwhile, in the guide apparatus 100, since the magnetic circuit M is formed within the plane substantially orthogonal to the movement direction, the N pole or the S pole of the magnetic circuit M only passes accompanied by the movement of the slider 120. Accordingly, the force that is generated by magnetic hysteresis becomes smaller by no need to reverse the direction of the magnetic flux. Therefore, the guide 110 can be smoothly moved.

Further, grooves 112 and 122 are formed on the guide plane 111 and the facing plane 121, respectively. The groove (first groove section) 112 of the guide plane 111 and the groove (second groove section) 122 of the facing plane 121 are disposed to face each other. The reason why the grooves 112 and 122 are formed on the guide plane 111 and the facing plane 121, respectively, is that, if the grooves 112 and 122 are provided, a large restoration force in the X direction is generated between the slider 120 and the guide 110, compared with a case where the grooves 112 and 122 are not provided. That is, in the case where the grooves 112 and 122 are not provided, when a slider 120' moves in the X direction, magnetic fluxes (magnetic circuit M') at both ends that exist between the slider 120' and a guide 110' are only bent. Accordingly, a force (restoration force) that returns the slider 120 to a predetermined position in the X direction is small (see FIG. 4B). Meanwhile, in the case where the grooves 112 and 122 are provided, when the slider 120 moves in the X direction, magnetic fluxes (magnetic circuit M) are bent for all protruding portions 113 and 123 of the slider 120 and the guide 110. Accordingly, a restoration force that returns the slider 120 to a predetermined position in the X direction becomes large (see FIG. 4A). That is, if the grooves 112 and 122 are provided, the number of magnetic fluxes that are bent when the slider 120 moves in the X direction can be easily and reliably increased, and thus a strong restoration force to the X direction can be obtained.

When the slider 120 is moved in the Y direction with respect to the guide 110, the magnetic circuit M travels inside the guide plane 111 formed of a metal material. Accordingly, an eddy current is generated inside the guide plane 111, and a resistive force that interferes with the movement to the Y direction is generated in the slider 120. The resistive force becomes larger as a large eddy current occurs, that is, as the movement speed of the slider 120 is high. In order to cancel the resistive force to be generated by the eddy current, a driving force of the slider 120 (a thrust of the Y linear motor 24) may be increased. However, in this case, the size and weight of the apparatus may be increased and costs may become high.

In this embodiment, as shown in FIG. 3A, the guide 110 (guide plane 111) has a laminate 116 in which a plurality of thin plate members 114 are laminated. The plate members 114 are formed of an electromagnetic steel plate, such as a silicon steel plate. The plate members 114 are laminated in the Y direction such that each of interfaces 114a is substantially parallel to the XZ plane. For the adhesion of the respective plate members 114, an adhesive having high electrical resistance, such as an epoxy-based adhesive, is used.

In this structure, if the slider 120 moves along the Y direction, an eddy current occurs in the guide plane 111. However, the guide plane 111 has a structure in which the thin plate members 114 are laminated in the Y direction, and the adhesive having high electrical resistance is interposed between the plate members 114. Accordingly, the eddy current is retained in the respective plate members 114, and thus a minimal eddy current occurs. Therefore, an eddy current occurring in the guide plane 111 is suppressed, and thus the resistive force to be generated in the slider 120 becomes small.

In such a manner, by suppressing an eddy current occurring in the guide 110, the occurrence of a resistive force to the slider 120 is suppressed, and the slider 120 can be smoothly moved with a minimal thrust.

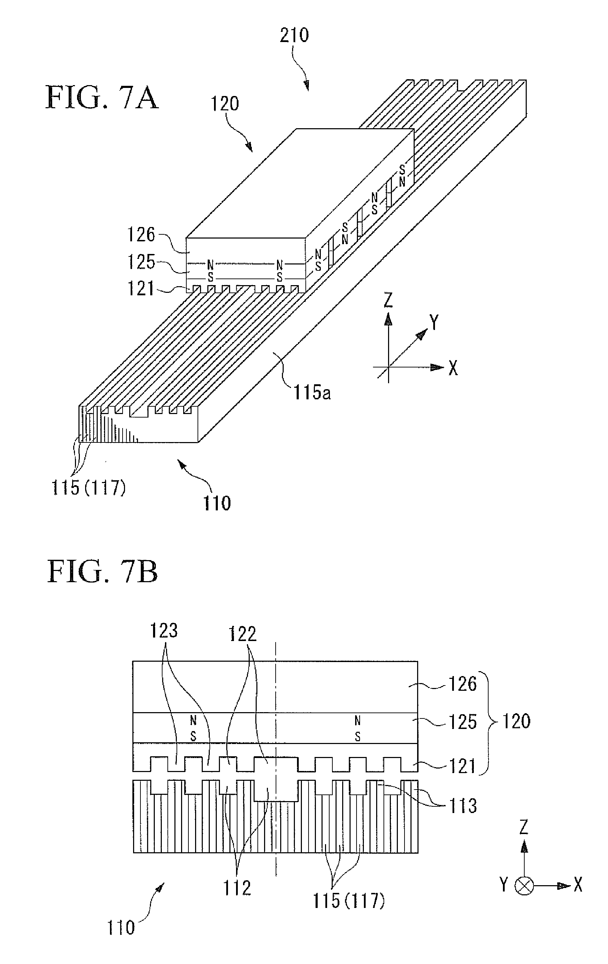

Moreover, as shown in FIGs. 7A and 7B, the guide 110 (guide plane 111) may have a laminate 117 in which plate members 115 formed of an electromagnetic steel plate, such as a silicon steel plate are laminated along the X direction to be substantially parallel to the YZ plane. That is, the plate members 115 are laminated in the X direction in a state where interfaces 115 of the plate members 115 formed of an electromagnetic steel plate, such as a silicon steel plate, are substantially parallel to the YZ plane. As described above, if the slider 120 is moved along the Y direction, an eddy current occurs in the guide plane 111. However, since the guide plane 111 is formed by laminating the thin plate members 115 in the X direction, a minimal eddy current occurs in each of the plate members 115. Therefore, an eddy current occurring in the guide plane 111 is suppressed, and thus a resistive force to be generated to the slider 120 becomes small.

In such a manner, the slider 120 can be smoothly moved with a minimal thrust.

FIG. 5 is a diagram showing the arrangement of the guide apparatus 100 and the air bearings 150.

The air bearings (fluid bearings) 150 are provided between the reticle platform 23 and the reticle coarse movement stage 21 such that the slider 120 (reticle coarse movement stage 21) is floated by a predetermined amount in the Z direction with respect to the guide 110 (reticle platform 23).

As shown in FIG. 5, the air bearings 150 are disposed at both sides in the X direction between the guide plane 111 and the facing plane 121. An air bearing main body 151 that ejects air is provided in the side of the reticle coarse movement stage 21, and a bearing plane 152 is formed at a position facing the air bearing main body 151 in the side of the reticle platform 23. The bearing plane 152 may be a flat surface having predetermined flatness.

With this structure, the slider 120 can be moved along the guide 110 in a state where the guide plane 111 of the guide 110 and the facing plane 121 of the slider 120 are constantly kept to be substantially parallel to each other. That is, the reticle coarse movement stage 21 is guided in the Y direction while being floated in the Z direction by a predetermined amount with respect to the reticle platform 23.

In FIG. 5, the air bearing main body 151 protrudes from the lower surface of the reticle coarse movement stage 21, but the air bearing main body 151 may be buried into the lower surface of the reticle coarse movement stage 21. Further, the air bearing main body 151 may be provided in the side of the reticle platform 23, and the bearing plane 152 may be provided in the side of the reticle coarse movement stage 21.

As described above, according to the guide apparatus 100, since the grooves 112 and 122 are provided on the guide plane 111 and the facing plane 121, a restoration force to the non-movement direction (Y direction) in the guide apparatus 100 can be improved. Further, since the magnetic circuit M that is formed through the guide plane 111 and the facing plane 121 is formed within the plane substantially orthogonal to the movement direction, a force to be generated by magnetic hysteresis can be suppressed, and thus the guide 110 can be smoothly moved. In addition, by suppressing the occurrence of the eddy current in the guide plane 111, the occurrence of a resistive force in the slider 120 is suppressed. Therefore, the guide 110 can be smoothly moved with a small thrust.

In the reticle stage 20 using such a guide apparatus 100, rigidity in the non-movement direction of the stage is improved, and thus a favorable control can be performed. Therefore, the minute pattern PA can be exposed onto the wafer W.

Next, modifications of the guide apparatus will be described.

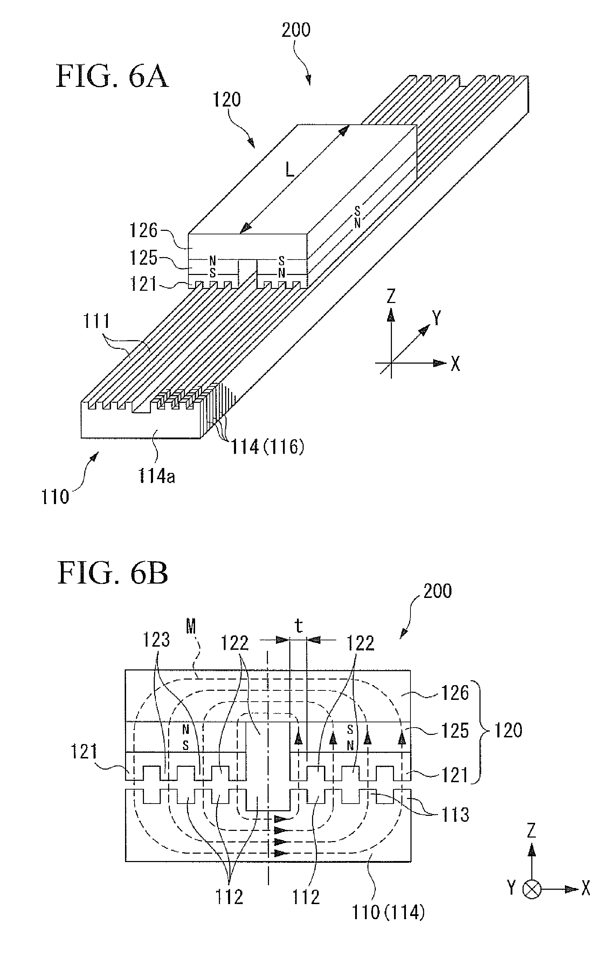

FIGs. 6A and 6B are a perspective view and a cross-sectional view showing a guide apparatus 200. Moreover, the same components and members as those of the guide apparatus 100 are represented by the same reference numerals, and the descriptions thereof will be simplified or omitted.

A plurality of grooves 112 and 122 are formed on each of a guide plane 111 and a facing plane 121 of the guide apparatus (magnetic guide apparatus) 200. As described above, if the grooves 112 and 122 are provided, a restoration force to the non-movement direction (X direction) can be improved. In particular, if a plurality of grooves 112 and 122 are formed, the restoration force can be further improved.

A width "t" of each of portions (protruding portion 113 or 123) other than the grooves 112 or 122 can be defined according to a permissible movement distance of the slider 120 in the X direction. That is, when the slider 120 moves by the substantially same distance as the width "t" of each of the protruding portions 113 or 123 in the X direction with respect to the guide 110, a maximum restoration force is generated. For this reason, if the width "t" of each of the protruding portions 113 or 123 is defined according to the permissible movement distance of the slider 120 in the X direction, the position of the slider 120 in the X direction can be more reliably fixed within the permissible movement distance.

Moreover, the widths "t" of all the protruding portions 113 or 123 do not need to be the same. For example, the width "t" of the outermost protruding portion 113 or 123 may be defined according to the permissible movement distance to the X direction. However, in order to generate a large restoration force, the widths of all the protruding portions 113 or 123 are preferably the same. As regards the grooves 112 and 122, the widths of all the grooves 112 and 122 do not need to be the same.

Further, the width "t" of the protruding portions 113 or 123 may be defined on the basis of a relational expression in respects to a length of the facing plane 121 in the Y direction and a saturated magnetic flux density of the plate member 114. That is, when a magnetic flux to be generated from one permanent magnet 125 is Φ, the saturated magnetic flux density of each of the plate members 114 of the guide 110 is Bc, and a length of the facing plane 121 in the Y direction is L, the expression Φ/(the number of protruding portions x the width "t" x L) ≤ Bc (constant value) is established. Specifically, even though the total area of the protruding portions 113 or 123 in the facing plane 121 (the number of protruding portions 113 or 123 x the width "t" of the protruding portion 113 or 123 x L) increases, the magnetic flux Φ to be generated from one permanent magnet 125 is constant, and then a magnetic flux density B becomes small. Accordingly, there is a inconvenience in that the restoration force does not increase but the gravity increases.

In order to solve the above inconvenience, it is necessary to define the number of protruding portions 113 or 123 and the width "t" of the protruding portion 113 or 123 such that the magnetic flux density B of each of the plate members 114 is substantially the same as the saturated magnetic flux density Bc.

FIGs. 7A and 7B are a perspective view and a cross-sectional view showing a guide apparatus 210 according to another modification.

In the guide apparatus (magnetic guide apparatus) 210, a plurality of permanent magnets 125 (in FIGs. 4A and 4B, four permanent magnets) that are provided in the guide 110 are arranged along the movement direction. The magnets are disposed such that their polarities facing the guide plane 111 are alternately changed along to the Y direction. Therefore, a plurality of magnetic circuits are formed between the guide 110 and the slider 120 along a plane substantially parallel to the YZ plane.

In the guide apparatus 210, the plate members 115 are laminated along the X direction to be substantially parallel to the YZ plane. Accordingly, an eddy current occurring in the guide 110 (guide plane 111) can be suppressed, and thus a resistance force to be generated in the slider 120 can be reduced. Moreover, the material of the plate members 115 or the adhesive for adhering the respective plate members 115 is the same as the guide apparatus 100.

Accordingly, if the slider 120 is moved along the Y direction, an eddy current occurs in the guide plane 111. However, since the respective plate members 115 that form the guide plane 111 are formed to be thin in the X direction, a minimal eddy current occurs in each of the plate members 115. Therefore, the eddy current occurring in the guide 110 is suppressed, and the resistive force to be generated in the slider 120 becomes small.

Moreover, like FIGs. 3A and 3B, the plate members 114 each formed of an electromagnetic steel plate, such as a silicon steel plate, may be laminated along the Y direction to be substantially parallel to the XZ plane. Even though an eddy current occurs in the guide plane 111, since the respective plate members 114 that form the guide plane 111 are formed to be thin, a minimal eddy current occurs in each of the plate members 114. Therefore, the eddy current occurring in the guide plane 111 is suppressed, and the resistive force to be generated in the slider 120 becomes small.

In such a manner, the slider 120 can be smoothly moved with a small thrust.

As the application of the above-described guide apparatus 100, 200, or 210, an example that uses the guide apparatus 100, 200, or 210 as a guide mechanism of the reticle coarse movement stage 21 has been described. However, the invention is not limited thereto.

For example, it may be used as a guide mechanism of the stator (mass body) 24a of the linear motor that moves in the Y direction as the counter mass. Further, the invention is not limited to the stage apparatus, such as the reticle stage 20, which moves in one direction. For example, the guide apparatus 100, 200, or 210 may be applied to a stage apparatus, such as the wafer stage 40, which moves in two directions of the X and Y directions. Of course, the guide apparatus 100, 200, or 210 may be used as a guide apparatus of a member that moves in the Z direction.

Further, each of the guide apparatus 100, 200, or 210 is configured such that the magnetic attractive force operates between the guide plane 111 and the facing plane 121. For this reason, in a structure in which a self-weight of the reticle coarse movement stage 21 is supported by the air bearings 150 or the like, if such a guide apparatus 100, 200, or 210 is used, in addition to the amount corresponding to the self-weight of the reticle coarse movement stage 21, a force that operates in a direction, in which the guide plane 111 and the facing plane 121 are separated from each other, is needed in order to cancel the magnetic attractive force. Accordingly, a plurality of guide apparatuses 100, 200, or 210 may be prepared in pairs and kept in a non-contact state such that magnetic attractive force to be generated in one guide apparatus 100, 200, or 210 of the pair and magnetic attractive force to be generated in the other guide apparatus 100, 200, or 210 of the pair are substantially offset with each other.

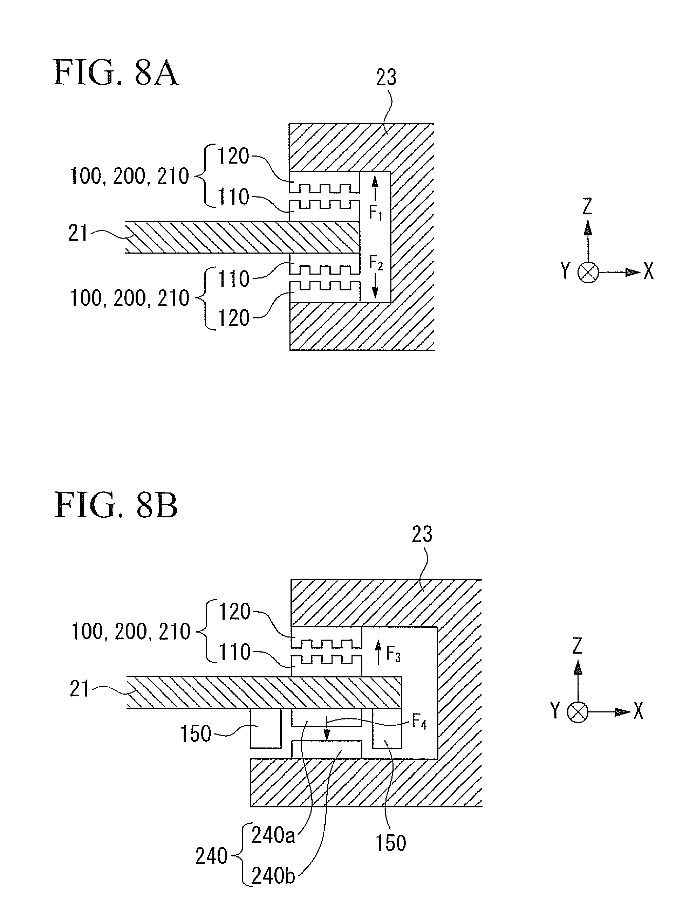

To this end, for example, the structure shown in FIG. 8A can be used. In FIG. 8A, a pair of the guide apparatuses 100, 200, or 210 are disposed between the upper surface of the reticle coarse movement stage 21 and the reticle platform 23 and between the lower surface of the reticle coarse movement stage 21 and the reticle platform 23. Here, all the permanent magnets 125 that cause the magnetic attractive force can be supposed to be disposed in the side of the slider 120. In this case, in the guide apparatus 100, 200, or 210 disposed between the upper surface of the reticle coarse movement stage 21 and the reticle platform 23, magnetic attractive force F1 in the +Z direction operates.

In contrast, in the guide apparatus 100, 200, or 210 disposed between the lower surface of the reticle coarse movement stage 21 and the reticle platform 23, magnetic attractive force F2 in the -Z direction operates. If the magnitudes of the magnetic attractive forces F1 and F2 are the same, the magnetic attractive forces F1 and F2 are balanced. Then, unlike the above description, even though the air bearings are not used, the magnetic attractive forces can be cancelled. For this reason, it is enough that the air bearings are set as much capacity as to support the self-weight of the reticle coarse movement stage 21. Further, the magnitudes of the magnetic attractive forces F1 and F2 may be adjusted such that the reticle coarse movement stage 21 can be floated even though the air bearings are not provided.

Moreover, the guide apparatus 100, 200, or 210 that is disposed at the upper surface of the reticle coarse movement stage 21 and the guide apparatus 100, 200, or 210 that is disposed at the lower surface of the reticle coarse movement stage 21 may be disposed at the substantially same positions on the XY plane such that the magnetic attractive forces F1 and F2 operate on the reticle coarse movement stage 21 at the substantially same position. However, the invention is not limited thereto.

Further, any device that causes attractive force between the reticle coarse movement stage 21 and the reticle platform 23 may be used as the actuator 24 or the like that moves the reticle coarse movement stage 21 relative to the reticle platform 23, such that the attractive force and the magnetic attractive force of the guide apparatus 100, 200, or 210 are offset with each other.

To this end, for example, a structure shown in FIG. 8B can be used. In FIG. 8B, the guide apparatus 100, 200, or 210 is disposed between the upper surface of the reticle coarse movement stage 21 and the reticle platform 23. The permanent magnets 125 that cause magnetic attractive force are supposed to be provided in the side of the slider 120.

In contrast, an actuator 240 is disposed between the lower surface of the reticle coarse movement stage 21 and the reticle platform 23. The actuator 240 generates a driving force in the Y direction so as to move the reticle coarse movement stage 21 in the Y direction with respect to the reticle platform 23. Structurally, the actuator 240 is configured to cause attractive force F4 between a moving element 240a and a stator 240b. As the actuator 240, for example, a cored linear motor that is generally known as a three-phase cored linear motor may be used. In the cored linear motor, magnetic attractive force by which the moving element and the stator attract each other as well as a driving force by which the moving element and stator relatively moves each other act on between the moving element and the stator. Moreover, the number of phases of the cored linear motor is not limited to three, but it may be arbitrarily set. Further, the method is not particularly limited. For example, one that has a structure of a pulse motor or one that is provided with inductor teeth in a magnetic body and generates a thrust by a so-called electromagnetic gear principle may be used. For example, such a cored linear motor is disclosed in Japanese Patent Application, Publication No. 2003-022960 and is used in a stage for an exposure apparatus.

Magnetic attractive force F3 of the +Z direction operates in the guide apparatus 100, 200, or 210, and the attractive force F4 of the -Z direction operates in the actuator 240. If the magnitudes of the magnetic attractive force F3 and the attractive force F4 are the same, the attractive forces F3 and F4 are balanced. Then, unlike the above description, even though the air bearings are not used, the magnetic attractive forces can be cancelled. For this reason, it is enough that the air bearings 150 are set as much capacity as to support the self-weight of the reticle coarse movement stage 21. Further, the magnitudes of the magnetic attractive force F3 and the attractive force F4 may be adjusted such that the reticle coarse movement stage 21 can be floated even though the air bearings 150 are not provided.

Moreover, the guide apparatus 100, 200, or 210 and the actuator 240 may be disposed at the substantially same positions on the XY plane, such that the magnetic attractive force F3 and the attractive force F4 operate on the reticle coarse movement stage 21 at the substantially same position. However, the invention is not limited thereto.

Although the embodiments of the invention have been described, the operation sequence, or the shapes or combinations of the respective components described in the above-described embodiments are just examples. Various modifications can be made without departing from the subject matter of the invention on the basis of process conditions or design demands. The following modifications still fall within the scope of the invention.

For example, in order to cause magnetic attractive force by the magnetic circuit M to operate between the guide plane 111 and the facing plane 121, the permanent magnets 125 and the yoke 126 are provided in the side of the slider 120 (reticle coarse movement stage 21). Alternatively, the permanent magnets 125 and the yoke 126 may be provided in the side of the guide plane 111 (guide 110). In this case, as a countermeasure against an eddy current, the facing plane 121 of the slider 120 may be formed by plate members laminated in the Y direction, as described above.

Although the guide 110 and the reticle platform 23 have been described as separate members, they may be formed as a single body. For example, the entire reticle platform 23 may be formed of a magnetic body or an electromagnetic steel plate, and the groove section 112 may be provided at a position where the guide plane 111 is to be formed. Then, two grooves may be provided on both sides interposing the groove section 112 therebetween, to be parallel to the groove section 112. In this case, a region that is formed between the two grooves to include the groove section 112 functions as the guide plane 111. In addition, as a countermeasure against an eddy current, the reticle platform 23 may be formed by plate members laminated in the Y direction, as described above.

In order to form the magnetic circuit M, instead of the permanent magnet 125, an electromagnet may be used. In this case, a current to be supplied may be appropriately set such that the poles alternately appear in a direction (X direction) orthogonal to the movement direction (Y direction) (for example, as shown in FIG. 3A).

As the countermeasure against the eddy current, the guide plane 111 or the facing plane 121 is formed by laminating a plurality of plate members. However, in order to suppress the occurrence of the eddy current, other means may be used. For example, as the material for the guide plane 111 or the facing plane 121, a material that suppresses the occurrence of the eddy current may be used.

Although the description has been given by way of the step-and-scan type exposure apparatus in the above-described embodiment, the invention can be applied to a step-and-repeat type exposure apparatus. Further, the invention can be applied to an exposure apparatus that is used in manufacturing a display, such as a liquid crystal display (LCD) or the like, and transfers a device pattern onto a glass plate, an exposure apparatus that is used in manufacturing a thin film magnetic head and transfers a device pattern onto a ceramic wafer, and an exposure apparatus that is used in manufacturing an imaging device, such as a CCD or the like, in addition to an exposure apparatus that is used in manufacturing a semiconductor device. In addition, the invention can be applied to an exposure apparatus that transfers a circuit pattern onto a glass substrate or a silicon wafer in order to manufacture a reticle or a mask to be used in a light exposure apparatus, an EUV exposure apparatus, an X-ray exposure apparatus, an electron beam exposure apparatus or the like. Here, a transmissive reticle is used in general in an exposure apparatus that uses DUV (deep ultraviolet) light, VUV (vacuum ultraviolet) light or the like. As the reticle substrate, quartz glass, quartz glass with fluorine doped, fluorite, magnesium fluoride, quartz crystal, or the like is used. Further, a transmissive mask (stencil mask or a membrane mask) is used in a proximity type X-ray exposure apparatus, an electron beam exposure apparatus or the like. As the mask substrate, a silicon wafer or the like is used.

As described in Japanese Patent Application, Publication No. H08-330224 (corresponding to US Patent No. 5,874,820), a frame member may be used to mechanically let the reaction force be bypassed to the floor (ground) such that the reaction force to be generated by the movement of the reticle stage is not transferred to the projection optical system.

As described in Japanese Patent Application, Publication No. H08-166475 (corresponding to US Patent No. 5,528,118), a frame member may be used to mechanically let the reaction force be bypassed into the floor (ground) such that the reaction force to be generated by the movement of the wafer stage is not transferred to the projection optical system.

Next, an embodiment of a microdevice manufacturing method that uses the exposure apparatus and the exposure method according to the embodiment of the invention for a lithography process will be described.

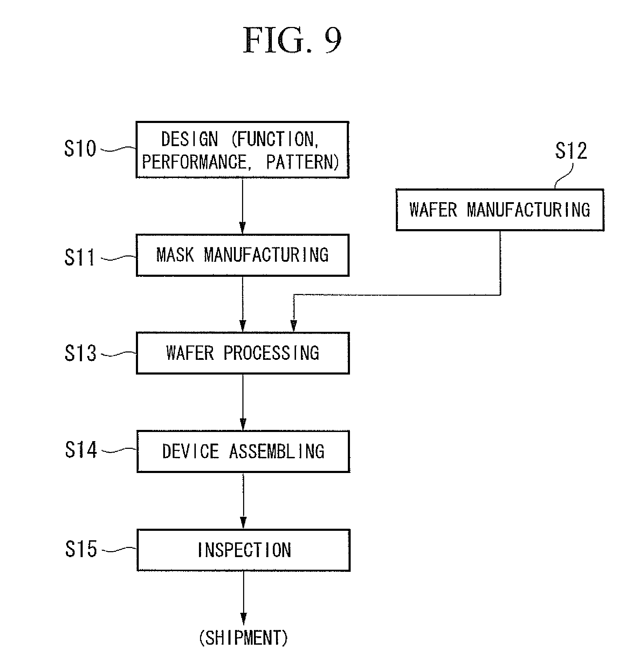

FIG. 9 is a flowchart of a manufacturing example of a microdevice (a semiconductor chip, such as an IC or an LSI, a liquid crystal panel, a CCD, a thin film magnetic head, or a micromachine).

First, at Step S10 (design step), function/performance design of the microdevice (for example, circuit design of a semiconductor device or the like) is performed, and pattern design for implementing the function is performed. Subsequently, at Step S11 (mask manufacturing step), a mask (reticle) on which the designed circuit pattern is formed is manufactured. Meanwhile, at Step S 12 (wafer manufacturing step), a wafer is manufactured by a silicon material or the like.

Next, at Step S 13 (wafer processing step), an actual circuit and the like is formed on the wafer by a lithography technique or the like using the mask and the wafer prepared at Steps S10 to S12, as described below. Next, at Step S 14 (device assembling step), device assembling is performed using the wafer processed at Step S13. At Step S14, processes, such as a dicing process, a bonding process, and a packaging process (chip sealing), are included, if necessary. Finally, at Step S15 (inspection step), inspections, such as an operation check test and a durability test of the microdevice manufactured at Step S 14, are performed. After these processes, the microdevice is completed and shipped out.

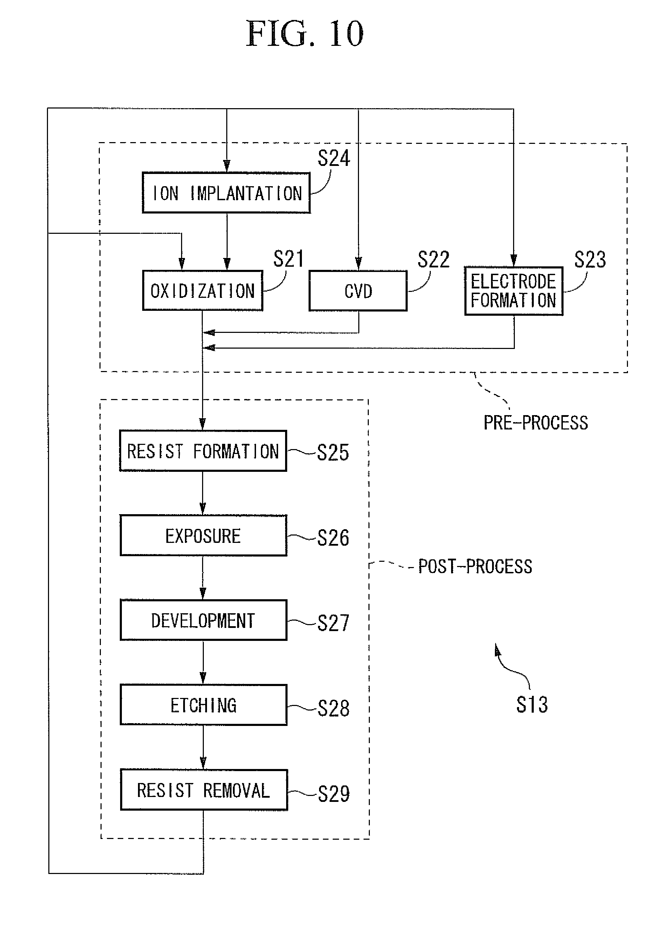

FIG. 10 is a diagram showing an example of a detailed process of Step S13 in case of a semiconductor device.

At Step S21 (oxidization step), the surface of the wafer is oxidized. At Step S22 (CVD step), an insulating film is formed on the surface of the wafer. At Step S23 (electrode forming step), an electrode is formed on the wafer by vapor deposition. At Step S24 (ion implantation step), ions are implanted into the wafer. Steps S21 to S24 correspond to a pre-process of respective steps for the wafer process, and are selectively performed according to the processing required in the respective steps.

If the above-described pre-process in the respective steps of the wafer processing is finished, a post-process is performed as follows. In the post-process, first, at Step S25 (resist formation step), a sensitizer is applied to the wafer. Subsequently, at Step S26 (exposure step), the circuit pattern of the mask is transferred onto the wafer using the lithography system (exposure apparatus) and the exposure method described above. Next, at Step S27 (development step), the exposed wafer is developed, and, at Step S28 (etching step), an exposed member of an area other than the area where the resist remains, is removed by etching. Then, at Step S29 (resist removing step), any unnecessary resist after etching is finished is removed. The pre-process step and the post-process step are repeatedly performed, and then multiple circuit patterns are formed on the wafer.

The invention can be applied to an exposure apparatus that transfers a circuit pattern from a mother reticle onto a glass substrate or a silicon wafer in order to manufacture a reticle or a mask to be used in a light exposure apparatus, an EUV exposure apparatus, an X-ray exposure apparatus, and an electron beam exposure apparatus, in addition to the microdevice, such as the semiconductor device or the like. Here, a transmissive reticle is used in an exposure apparatus that uses DUV (deep ultraviolet) light, VUV (vacuum ultraviolet) light or the like. As the reticle substrate, quartz glass, quartz glass with fluorine doped, fluorite, magnesium fluoride, quartz crystal, or the like is used. Further, a transmissive mask (stencil mask or a membrane mask) is used in a proximity type X-ray exposure apparatus, an electron beam exposure apparatus or the like. As the mask substrate, a silicon wafer or the like is used. Such an exposure apparatus is disclosed in PCT International Publication Nos. WO99/34255, WO99/50712, WO99/66370, Japanese Patent Application, Publication Nos. H11-194479, 2000-12453, 2000-29202 and the like.

Further, the invention can be applied to a liquid immersion type exposure apparatus that forms a predetermined pattern on a substrate through a liquid supplied between the projection optical system and the substrate (wafer) after a necessary liquid countermeasure is appropriately performed. The structure and exposure operation of the liquid immersion type exposure apparatus are disclosed, for example, in the PCT International Publication No. WO99/49504, Japanese Patent Application, Publication Nos. H06-124873, and H10-303114. Further, the invention can also be applied to a twin-stage type exposure apparatus. The structure and exposure operation of the twin-stage type exposure apparatus is disclosed, for example, in Japanese Patent Application, Publication Nos. H10-163099, H10-214783, Published Japanese Translation No.2000-505958, or US Patent No. 6,208,407. In addition, the invention can also be applied to an exposure apparatus that includes an exposure stage configured to be movable while holding a substrate to be processed, such as a wafer or the like, and a measurement stage having various measurement members or sensors, as disclosed in Japanese Patent Application, Publication No. H11-135400.

## Claims

1. A magnetic guide apparatus comprising:
a guide member that has a guide plane provided along a first direction; and
a moving body that has a facing plane facing the guide plane to be spaced apart from the guide plane,
wherein magnetic attractive force is permitted to operate between the guide plane and the facing plane, such that the moving body is moved along the first direction while movement to a second direction, which is orthogonal to the first direction and parallel to the guide plane, is controlled,
wherein a first groove section is formed along the first direction on the guide plane, and
wherein a second groove section is formed along the first direction on the facing plane so as to face the first groove section.

2. The magnetic guide apparatus according to claim 1,
wherein a plurality of groove sections are formed on each of the guide plane and the facing plane.

3. The magnetic guide apparatus according to claim 1 or 2,
wherein the guide member or the moving body has a magnet member that, through the guide plane and the facing plane, forms a magnetic circuit within a plane orthogonal to each of the first direction and the facing plane.

4. The magnetic guide apparatus according to claim 3,
wherein the magnetic circuit is formed in two or more.

5. The magnetic guide apparatus according to claim 3 or 4,
wherein the magnet member is a plurality of permanent magnets that are arranged with alternating polarities.

6. The magnetic guide apparatus according to claim 3 or 4,
wherein the magnet member is a plurality of electromagnets that are arranged with alternating polarities.

7. The magnetic guide apparatus according to any one of claims 3 to 6,
wherein the moving body or the guide member is configured to reduce a resistive force to the moving body to be generated when the moving body moves along the guide plane.

8. The magnetic guide apparatus according to any one of claims 3 to 6,
wherein, when the guide member has the magnet member, the moving body is configured to reduce the resistive force to the moving body to be generated when the moving body moves along the guide plane, and
when the moving body has the magnet member, the guide member is configured to reduce the resistive force to the moving body to be generated when the moving body moves along the guide plane.

9. The magnetic guide apparatus according to claim 7 or 8,
wherein the moving body or the guide member has a laminate in which a plurality of plate members are laminated.

10. The magnetic guide apparatus according to claim 9,
wherein, in the laminate, each of interfaces of the plurality of plate members is parallel to a plane that is orthogonal to each of the first direction and the facing plane.

11. The magnetic guide apparatus according to claim 9,
wherein, in the laminate, each of interfaces of the plurality of plate members is parallel to a plane that is orthogonal to each of the second direction and the facing plane.

12. The magnetic guide apparatus according to any one of claims 1 to 11,
wherein a width of a protruding portion of the facing plane excluding the groove section is defined by a permissible movement distance of the plate members to the second direction.

13. The magnetic guide apparatus according to any one of claims 9 to 11,
wherein a width of a protruding portion of the facing plane excluding the groove section is defined on the basis of a relational expression in respects to a length of the facing plane in the first direction and a saturated magnetic flux density of each of the plate members.

14. A magnetic guide apparatus comprising:
a guide member that has a guide plane provided along a first direction; and
a moving body that has a facing plane facing the guide plane to be spaced apart from the guide plane,
wherein magnetic attractive force is permitted to operate between the guide plane and the facing plane, such that the moving body is moved along the first direction while movement to a second direction, which is orthogonal to the first direction and parallel to the guide plane, is controlled, and
wherein either the guide member or the moving body has a magnet member that, through the guide plane and the facing plane, forms a magnetic circuit within a plane orthogonal to each of the first direction and the facing plane.

15. The magnetic guide apparatus according to claim 14,
wherein the magnetic circuit is formed in two or more.

16. A magnetic guide apparatus comprising:
a guide member that has a guide plane provided along a first direction; and
a moving body that has a facing plane facing the guide plane to be spaced apart from the guide plane,
wherein magnetic attractive force is permitted to operate between the guide plane and the facing plane, such that the moving body is moved along the first direction while movement to a second direction, which is orthogonal to the first direction and parallel to the guide plane, is controlled,
wherein either the guide member or the moving body has a magnet member that forms a magnetic circuit through the guide plane and the facing plane, and
wherein the guide member or the moving body is configured to reduce a resistive force to the moving body to be generated when the moving body moves along the guide plane.

17. The magnetic guide apparatus according to claim 16,
wherein the moving body or the guide member has a laminate in which a plurality of plate members are laminated.

18. The magnetic guide apparatus according to claim 17,
wherein, in the laminate, each of interfaces of the plurality of plate members is parallel to a plane that is orthogonal to each of the first direction and the facing plane.

19. The magnetic guide apparatus according to claim 17,
wherein, in the laminate, each of interfaces of the plurality of plate members is parallel to a plane that is orthogonal to each of the second direction and the facing plane.

20. A stage apparatus comprising:
a base; and
a stage that is relatively movable with respect to the base,
wherein the magnetic guide apparatus according to any one of claims 1 to 19 is used as a guide apparatus that is disposed between the base and the stage to relatively move the base and the stage only in a predetermined direction.

21. The stage apparatus according to claim 20,
wherein the base has a guide plane and a bearing plane that is provided at a different position from the guide plane, and
the stage has the moving body and fluid bearings that are provided to face the bearing plane to support the stage.

22. The stage apparatus according to claim 21,
wherein the fluid bearings are disposed at both sides of the magnetic guide apparatus relative to the second direction.

23. The stage apparatus according to claim 21,
wherein a plurality of magnetic guide apparatuses are provided in pairs, and
at least a pair of magnetic guide apparatuses are disposed such that magnetic attractive force, which is generated by one magnetic guide apparatus and operates between the guide plane and the facing plane, and magnetic attractive force, which is generated by the other magnetic guide apparatus and operates between the guide plane and the facing plane, are substantially offset with each other.

24. The stage apparatus according to claim 23, further comprising:
an actuator that relatively moves the base and the stage and generates attractive force operating between the base and the stage,
wherein magnetic attractive force to be generated by the magnetic guide apparatus is substantially offset by magnetic attractive force to be generated by the actuator.

25. The stage apparatus according to claim 20, further comprising:
a mass body that moves according to movement of the stage to suppress a reaction force to be generated by the movement of the stage,
wherein the magnetic guide apparatus according to any one of claims 1 to 19 is used as a guide apparatus that guides the mass body.

26. A stage apparatus comprising:
a base that has a guide plane provided along a first direction;
a stage that has a facing plane facing the guide plane to be spaced apart from the guide plane and is movable along the first direction, while movement of a second direction, which is orthogonal to the first direction and parallel to the guide plane, is controlled, by magnetic attractive force operating between the guide plane and the facing plane; and
fluid bearings that are provided between the base and the stage at a different position from the guide plane to support the stage with respect to the base.

27. The stage apparatus according to claim 26,
wherein the fluid bearings are disposed at both sides of the guide plane or the facing plane relative to the second direction.

28. An exposure apparatus that exposes a pattern formed in a mask to a substrate, the exposure apparatus comprising:
a mask stage that holds the mask; and
a substrate stage that holds the substrate,
wherein the stage apparatus according to any one of claims 20 to 27 is used for at least one of the mask stage and the substrate stage.

29. An exposure apparatus that forms a predetermined pattern in a substrate held by a substrate stage,
wherein the stage apparatus according to any one of claims 20 to 27 is used as the substrate stage.

30. A device manufacturing method that includes a lithography process,
wherein, in the lithography process, the exposure apparatus according to claim 28 or 29 is used.
